# EUROPEAN PATENT SPECIFICATION

(11) **EP 0 443 578 B1**
(45) Date of publication and mention of the grant of the patent: **16.08.1995**
(21) Application number: 91102547.6
(22) Date of filing: 21.02.1991
(51) Int. Cl.: H05K 1/11

(54) **Multilayer ceramic wiring substrate and pin connecting structure**
Mehrschicht keramisches Verdrahtungssubstrat und Stiftverbindungsstruktur
Substrat de câblage céramique multi-couche et structure de connexion de pointes

(30) Priority: 22.02.1990 JP 42938/90; 29.03.1990 JP 82707/90
(43) Date of publication of application: 28.08.1991
(73) Proprietor: NEC CORPORATION, Tokyo (JP)
(72) Inventor: Inasaka, Jun, c/o NEC Corporation, Minato-ku, Tokyo (JP)
(74) Representative: Pätzold, Herbert, Dr.-Ing.

(56) References cited:
- JP-A-63 248 138
- US-A- 4 665 468
- US-A- 4 736 276

## Description

### Background of the Invention

The present invention relates to a multilayer ceramic wiring substrate and its pin connecting structure for external connection.

A multilayer ceramic wiring substrate according to the preamble of claim 1 is disclosed in US-A-4 665 468.

The pin connecting structure of a conventional multilayer wiring substrate of this type is designed such that lands are directly formed on the upper surface of the ceramic substrate, and pins are connected to the lands by brazing or the like.

In the above-mentioned conventional pin connecting structure, since the lands are directly brazed to the ceramic substrate, a stress is generated in the brazed portions due to a difference in thermal expansion coefficient between the lands or a brazing material on the lands and the ceramic. For this reason, cracks tend to be produced in a surface of a ceramic substrate, especially a surface of a substrate having low strength, such as an aluminum nitride substrate or a glass ceramic substrate.

### Summary of the Invention

It is a principal object of the present invention to provide a multilayer ceramic wiring substrate which can prevent cracking of a ceramic substrate by reducing a stress caused by a difference in thermal expansion coefficient between the ceramic substrate and each brazed portion.

It is another object of the present invention to provide a multilayer ceramic wiring substrate which allows easy positioning of a ceramic substrate in a baking process.

It is still another object of the present invention to provide a multilayer ceramic wiring substrate which requires no adjustment of a thermal expansion coefficient.

In order to achieve the above objects, there is provided a multilayer ceramic wiring substrate according to claim 1.

### Brief Description of the Drawings

Fig. 1 is a longitudinal sectional view of a multilayer ceramic wiring substrate according to an embodiment of the present invention; and
Fig. 2 is an enlarged sectional view showing a main part of the substrate.

### Detailed Description of the Preferred Embodiment

The present invention will be described below with reference to the accompanying drawings.

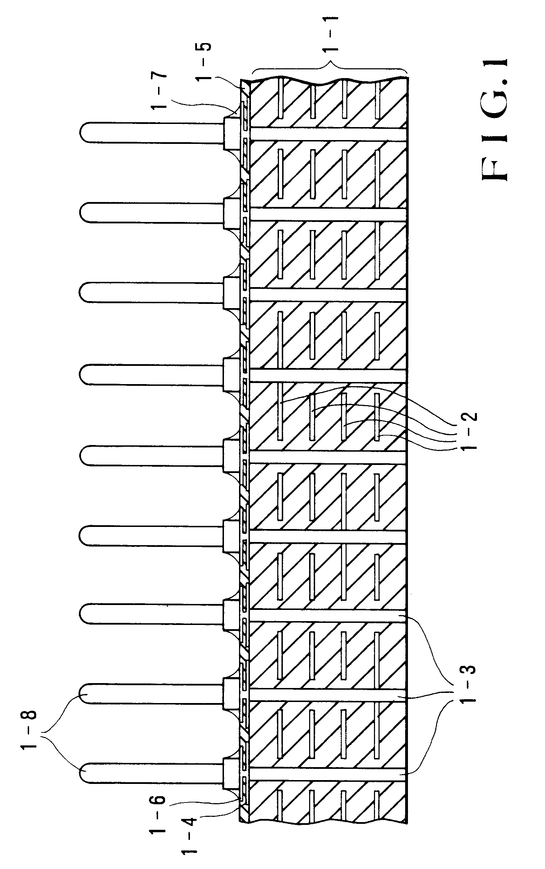

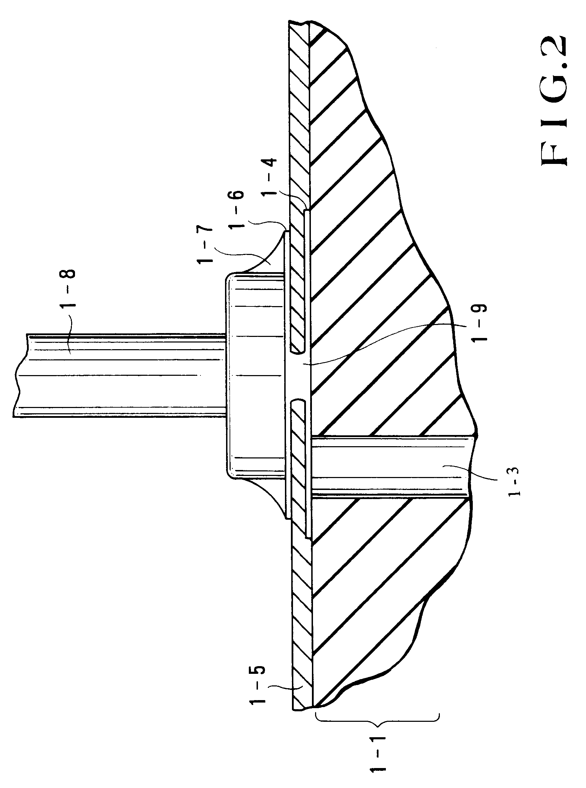

Fig. 1 shows an embodiment of the present invention. Fig. 2 shows a main part of the substrate.

Referring to Figs. 1 and 2, reference numeral 1-1 denotes a multilayer ceramic wiring substrate, which is designed such that conductive patterns 1-2 in the substrate are connected to through holes 1-3 for connecting an LSI mounting surface to an external connection pin mounting surface, and end portions of the through holes 1-3 are exposed on a substrate surface (pin mounting surface). The thermal expansion coefficient of the ceramic substrate is 4.2 x 10⁻⁶/°C. Each through hole 1-3 has a diameter of 100 to 300 »m. The through hole pitch is 2.54 mm. The through holes 1-3 and the conductive patterns 1-2 are composed of tungsten, a molybdenum-gold alloy, a silver-palladium alloy, or the like.

Reference numeral 1-4 denotes a land formed on the upper surface of the substrate 1-1. Each land 1-4 is constituted by a thick or thin film and has a diameter of 1.0 to 1.5 mm. Reference numeral 1-5 denotes a polyimide resin layer. The polyimide resin layer 1-5 has a thickness of 2 to 15 »m. The thermal expansion coefficient of the polyimide resin layer 1-5 is set to be 10.0 x 10⁻⁶/°C, which is selected as an intermediate value between the thermal expansion coefficient of the substrate and that of the brazing material. This polyimide resin layer 1-5 is coated on the substrate surface by spin coating while via holes 1-9 are formed in the polyimide resin layer 1-5, by photolithography, at positions where pins 1-8 are formed. If the lands 1-4 are not formed at this time, all the via holes 1-9 in the polyimide resin layer 1-5 must be accurately positioned to the respective through holes 1-3 in the ceramic substrate 1-1. Such positioning becomes increasingly difficult with an increase in area of a substrate. This is because an increase in area of a substrate causes great variations in shrinkage factor of the ceramic substrate 1-1 in the baking process. For this reason, when a substrate having a side of 2 cm or more is to be used, one of the following methods must be employed: forming via holes in units of divided regions on a substrate surface; and matching the pitch of via holes of a glass mask for exposure with variations in shrinkage factor. Although a difference in thermal expansion coefficient can be easily absorbed with an increase in thickness of the polyimide resin layer 1-5, the thickness of the layer 1-5 is preferably set to be 15 »m or less in order to reliably connect the upper surface of the layer 1-5 to the lands 2.

Reference numeral 1-6 denotes a land having a diameter of 1.3 mm, which is formed on the upper surface of the polyimide resin layer 1-5. Each land 1-6 is constituted by only a sputter film or a plating film such as a gold, copper, or nickel plating film by a normal thin-film conductive pattern forming method. When the land 1-6 is to be formed by only a sputter film, a 1,000-Å thick chromium film and a 4,000-Å to 6,000-Å thick palladium film are preferably deposited. If the thickness of the palladium film is smaller than the above-mentioned value, progress in diffusion of chromium up to the surface of the palladium film may cause a deterioration in wettability of a brazing material in pin brazing. In the method of selectively forming a sputter film on only portions corresponding to the lands 1-6, the upper surface of the polyimide resin layer 1-5 is masked with a metal mask so as not to deposit the sputter film on unnecessary portions in forming the sputter film, or a resist is coated on the sputter film formed on the entire surface of the layer 1-5, and the lands are formed by photolithography. When the lands 1-6 are to be formed by plating, after the sputter film is formed into lands, plated electrodes may be extracted from the lower surface of the substrate 1-1 by using the through holes, in the ceramic substrate, connected to the lands 1-6, or electroless plating is performed.

Reference numeral 1-7 denotes a brazing material for fixing the pins 1-8 to the lands. The pins 1-8 are used for external connection. Although a brazing material used in this case is a eutectic alloy (thermal expansion coefficient: 18 x 10⁻⁶/°C) having a gold/tin ratio of 80/20 (wt%), any brazing material having a melting point within a temperature range in which polyimide is free from damage (400°C or lower) can be used. The amount of brazing material must be changed depending on the size of the land 1-6. In this embodiment, the amount is 0.8 to 0.9 mg. The nail head portion of each pin 1-8 has a diameter of 0.7 mm, and the pin 1-8 has a diameter of 0.35 mm.

In this embodiment, the stress acting on each brazed portion is reduced by forming the polyimide resin layer, whose thermal expansion coefficient is adjusted to the intermediate value between the thermal expansion coefficient of the ceramic substrate 1-1 and that of the brazed portion of each pin 1-8. However, the stress acting on each brazed portion is reduced by utilizing the elasticity of the polyimide film without adjusting its thermal expansion coefficient to the intermediate value between the thermal expansion coefficient of the ceramic substrate and that of the brazing material.

As has been described above, according to the present invention, the stress based on the difference in thermal expansion coefficient between the ceramic substrate and each brazed portion is reduced by forming the polyimide resin layer between the ceramic substrate and the brazed portion of each pin and can be reduced adjusting the thermal expansion coefficient of the polyimide resin layer, thus preventing cracks.

## Claims

1. A multilayer ceramic wiring substrate (1-1) with pins (1-8) for external connection
characterised by
a polyimide resin layer (1-5) formed on the multilayer ceramic substrate (1-1) at the side of said pins (1-8) and having via holes (1-9) arranged at positions where said pins are connected to through holes (1-3) in the substrate, said through holes being filled with a conductive material, and first lands (1-6) formed on an upper surface of said polyimide resin layer (1-5) to cover the via holes (1-9) and where said pins (1-8) are respectively brazed to said first lands (1-6) by a brazing material (1-7).

2. A substrate according to claim 1, further comprising second lands (1-4) connected to the through holes (1-3) formed in the upper surface of said ceramic substrate.

3. A substrate according to claim 1, wherein said polyimide resin (1-5) layer has a thermal expansion coefficient selected to be an intermediate value between a thermal expansion coefficient of said ceramic substrate (1-1) and that of said brazing material (1-7).

## Patentansprüche

1. Mehrschichtiges keramisches Verdrahtungssubstrat (1-1) mit Anschlußstiften bzw. Pins (1-8) für den externen Anschluß,
gekennzeichnet durch
eine auf dem mehrschichtigen keramischen Substrat (1-1) ausgebildete Schicht (1-5) aus Polyimid-Kunststoff auf der Seite der Anschlußstifte (1-8), welche Durchführungen (1-9) aufweist, die an Positionen angeordnet sind, an denen die Anschlufßstifte mit Durchführungen (1-3) im Substrat verbunden sind, wobei die Durchführungen mit einem leitfähigen Material gefüllt sind, sowie durch erste Anschlußflächen (1-6), die auf einer Oberseite der Schicht (1-5) aus Polyimid-Kunststoff so ausgebildet sind, daß sie die Durchführungen (1-9) abdecken, und an denen die Anschlußstifte (1-8) jeweils mittels eines Hartlots (1-7) mit den ersten Anschlußflächen (16) hartverlötet sind.

2. Substrat nach Anspruch 1, welches des weiteren zweite Anschlußflächen (1-4) aufweist, die mit den in der Oberseite des keramischen Substrats ausgebildeten Durchführungen (1-3) verbunden sind.

3. Substrat nach Anspruch 1, bei welchem die Schicht (1-5) aus Polyimid-Kunststoff einen wärmeausdehnungskoeffizienten besitzt, der so gewählt ist, daß er einen Wert hat, der zwischen dem Wärmeausdehnungskoeffizienten des keramischen Substrats (1-1) und dem des Hartlots (1-7) liegt.

## Revendications

1. Substrat de câblage céramique multi-couche (1-1) avec des broches pour connexion externe,
caractérisé par
une couche de résine de polyimide (1-5) formée sur le substrat de câblage céramique multi-couche (1-1) du coté des dites broches (1-8) et comportant des trous traversants (1-9) disposés selon des positions telles que les dites broches soient reliées aux trous traversants (1-3) dans le substrat, les dits trous traversants étant remplis d' un matériau conducteur, et une première série de dépôts conducteurs (1-6) étant formée sur la surface supérieure de la dite couche de résine de polyimide (1-5) afin de recouvrir les trous traversants (1-9) et où les dites broches (1-8) sont respectivement brasées aux dits dépôts conducteurs (1-6) au moyen d' un matériau de brasage (1-7) .

2. Substrat selon la revendication 1 , comprenant de plus une deuxième série de dépôts conducteurs (1-4) connectés aux trous traversants(1-3) formés à la surface supérieure du dit substrat céramique.

3. Substrat selon la revendication 1, dans lequel la dite couche de résine de polyimide (1-5) possède un coefficient d' expansion thermique sélectionné pour être une valeur intermédiaire entre le coefficient d'expansion thermique du dit substrat céramique (1-1) et celui du dit matériau de brasage (1-7).
